## Europäisches Patentamt

## European Patent Office

## Office européen des brevets

(19)

(11) Veröffentlichungsnummer: **0 063 174**
**B1**

(12) **EUROPÄISCHE PATENTSCHRIFT**

(45) Veröffentlichungstag der Patentschrift:
29.01.86

(51) Int. Cl.⁴: **H 05 G 1/26**, G 01 R 15/02

(21) Anmeldenummer: 81108431.8

(22) Anmeldetag: 16.10.81

(54) Vorrichtung zum Messen der Röntgenröhrenhochspannung.

(30) Priorität: 10.04.81 DE 3114699

(43) Veröffentlichungstag der Anmeldung:
27.10.82 Patentblatt 82/43

(45) Bekanntmachung des Hinweises auf die Patenterteilung:
29.01.86 Patentblatt 86/5

(84) Benannte Vertragsstaaten:
DE FR GB

(56) Entgegenhaltungen:
US - A - 4 189 645
US - A - 4 203 033

(73) Patentinhaber: Siemens Aktiengesellschaft, Berlin und München Wittelsbacherplatz 2, D-8000 München 2 (DE)

(72) Erfinder: Aichinger, Horst, Dr.rer.nat.,
Unterfarrnbacherstrasse 32, D-8510 Fürth (DE)
Erfinder: Kranberg, Heinz Erik, Egidienstrasse 16c,
D-8520 Erlangen (DE)

## Beschreibung

Die Erfindung betrifft eine Vorrichtung zum Messen der Röntgenröhrenhochspannung gemäss dem Oberbegriff des Patentanspruches.

Eine Vorrichtung dieser Art ist in der US-A-4 189 645 beschrieben. Bei dieser Vorrichtung wird ein der Röntgenröhrenspannung entsprechendes Signal gebildet und angezeigt. Ferner wird die jeweilige Belichtungszeit über dieses Signal erfasst. Dieser Schrift ist jedoch nicht entnehmbar, wie die Ermittlung der Belichtungszeit erfolgt und ob Grenzen des Ausgangssignales des Dividierers zur Erfassung der Belichtungszeit herangezogen werden.

Es existieren Vorschriften, nach denen die Belichtungszeit für eine Röntgenaufnahme nur gemessen werden soll, wenn die Röntgenröhrenspannung grösser als oder gleich 75% der Röntgenröhrenspitzenspannung ist. Hierzu wird in bekannter Weise ein Oszillograph zur Erfassung des zeitlichen Verlaufes der Röntgenröhrenspannung benutzt. Anhand des so erfassten zeitlichen Verlaufes kann dann die Belichtungszeit unter Berücksichtigung dieser Vorschriften bestimmt werden.

Der Erfindung liegt die Aufgabe zugrunde, eine Vorrichtung der eingangs genannten Art so auszubilden, dass als Belichtungsdauer einer Röntgenaufnahme diejenige Zeitdauer erfasst wird, während der die Röntgenröhrenspannung grösser oder gleich einem gewählten Prozentsatz der Röntgenröhrenspitzenspannung ist.

Diese Aufgabe ist erfindungsgemäss durch die im Kennzeichen des Patentanspruches angegebene Ausbildung gelöst. Bei der erfindungsgemässen Vorrichtung ist der jeweilige aktuelle Zählerstand unmittelbar ein Mass für die Belichtungszeit unter Berücksichtigung der erwähnten Vorschriften.

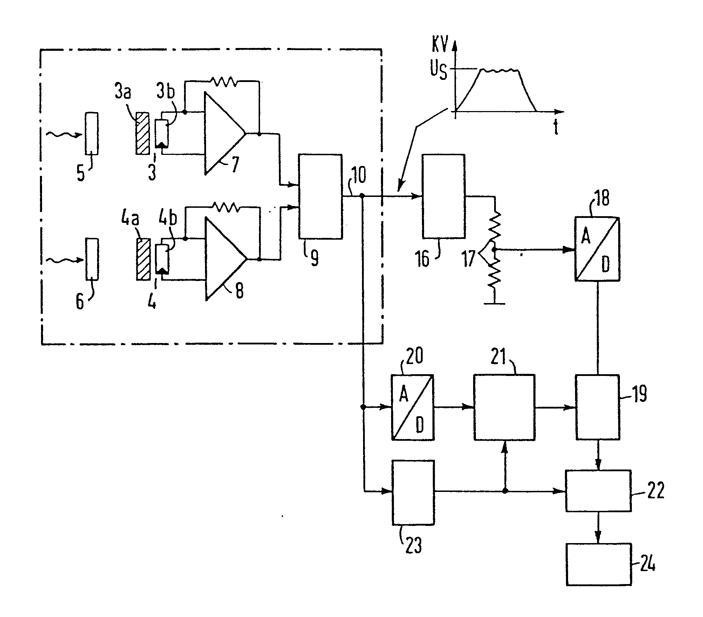

Die Erfindung ist nachfolgend anhand eines in der Zeichnung dargestellten Ausführungsbeispieles näher erläutert.

In der Zeichnung sind zur Messung der Röntgenröhrenhochspannung zwei Strahlendetektoren 3 und 4 dargestellt, die aus je einem Szintillationskristall 3a bzw. 4a und einer Fotodiode 3b bzw. 4b bestehen und auf ihren Eingangsseiten für die Strahlung durch zwei Röntgenstrahlenfilter 5 und 6 unterschiedlicher Absorption abgedeckt sind. Die Ausgangssignale der Strahlendetektoren 3 und 4 werden über Strom-Spannungswandler 7 und 8 einem Dividierer 9 zugeführt. Das Ausgangssignal des Dividierers 9 am Ausgang 10 stellt ein Mass für die Röntgenröhrenhochspannung dar.

Das der Röntgenröhrenhochspannung entsprechende Signal ist einem Spitzenwertspeicher 16 zugeführt, der den Spitzenwert des entsprechend der Röntgenröhrenhochspannung verlaufenden Signales ermittelt. Über einen nachgeschalteten Spannungsteiler 17 wird sofort der 75%-Wert gebildet. Nach Wandlung in einem Analog/Digital-Wandler 18 liegt der 75%-Wert in binärer Form an einem Eingang eines Vergleichers 19.

Das der Röntgenröhrenhochspannung entsprechende Signal am Ausgang 10 des Dividierers 9 wird ausserdem nach Wandlung in einem Analog/Digital-Wandler 20 einem Schieberegister 21 zugeführt. Die Speichergrösse des Schieberegisters 21 richtet sich nur nach der ansteigenden bzw. abfallenden Flanke der Hochspannungskurve. Erscheint am Ausgang des Schieberegisters 21 die ansteigende Flanke der Hochspannungskurve, so steht auch der 75%-Wert am Eingang des Vergleichers 19 an. Der Vergleicher 19 gibt einen Zähler 22 frei, wenn der jeweils anstehende Speicherinhalt grösser oder gleich 0,75× dem Spitzenwert der Röntgenröhrenspannung ist. Die Summe der auf diese Weise gezählten, von einem Taktgeber 23 gelieferten Taktimpulse ist gleich der Belichtungszeit unter Berücksichtigung der Vorschrift, dass diese nur dann gemessen werden soll, wenn die Röntgenröhrenspannung gleich oder grösser als 75% des Spitzenwertes ist. Sie kann mittels einer Anzeigevorrichtung 24 angezeigt werden.

## Patentanspruch

Vorrichtung zum Messen der Röntgenröhrenhochspannung bei einer Röntgendiagnostikanlage, die zwei Strahlendetektoren (3, 4) aufweist, die auf ihren Eingangsseiten für die Strahlung durch zwei Röntgenstrahlenfilter (5, 6) unterschiedlicher Absorption abgedeckt sind, und bei der ein Dividierer (9) für die beiden Ausgangssignale der Strahlendetektoren (3, 4) vorhanden ist, bei der das Ausgangssignal des Dividierers (9) einer Zeitmessschaltung (16 bis 24) zugeführt ist, die die Belichtungszeit erfasst, dadurch gekennzeichnet, dass die Zeitmessschaltung (16 bis 24) ein Prozentglied (16, 17) zum Bilden eines Signales aufweist, das einem bestimmten Prozentsatz des Spitzenwertes der anliegenden Röntgenröhrenspannung entspricht, und dass ein Vergleicher (19) vorhanden ist, der das Signal des Prozentgliedes (16, 17) mit dem Ausgangssignal eines Schieberegisters (21) vergleicht, dessen Eingangsinformation dem momentanen Wert der Röntgenröhrenspannung entspricht, und der einen Zähler (22) während des Zeitintervalls aktiviert, in dem die Röntgenröhrenspannung über dem gewählten Prozentsatz des Spitzenwertes liegt.

## Claim

A device for measuring the high-voltage of an X-ray tube in an X-ray diagnostic system, which has two radiation detectors (3, 4) covered by two X-ray filters (5, 6) of different absorption of their radiation input sides, and wherein is arranged a divider (9) for the two output signals of the radiation detectors (3, 4), wherein the output signal of the divider (9) is fed to a time-measuring circuit (16 to 24) which measures the period of exposure, characterised in that the time-measuring circuit (16 to 24) has a percentage element (16, 17) for forming a signal which corresponds to a specific percentage of the peak value of the connected X-ray tube voltage, and that a comparator (19) compares the signal of the percentage element (16, 17) with the output signal of a shift register (21), whose input information corresponds to the instantaneous value of the X-ray tube voltage, and which activates a counter (22) during the time in which the X-ray tube voltage lies above the selected percentage of the peak value.

## Revendication

Dispositif pour mesurer la haute tension d'un tube à rayons X dans une installation de radiodiagnostic, qui comporte deux détecteurs de rayonnement (3, 4), qui sont recouverts, sur leurs faces d'entrée du rayonnement, par deux filtres des rayons X (5, 6) réalisant des absorptions différentes, et dans lequel il est prévu un diviseur (9) pour les deux signaux de sortie des détecteurs de rayonnement (3, 4), et le signal de sortie du diviseur (9) est envoyé à un chronomètre (16 à 24), qui détecte la durée d'exposition, caractérisé par le fait que le chronomètre (16 à 24) comporte un circuit (16, 17) délivrant un pourcentage et servant à former un signal qui correspond à un pourcentage de la valeur maximale de la tension appliquée du tube à rayons X, et qu'il est prévu un comparateur (19) qui compare le signal du circuit (16, 17) délivrant un pourcentage au signal de sortie d'un registre à décalage (21), dont l'information d'entrée correspond à la valeur instantanée de la tension du tube à rayons X et qui active un compteur (22) pendant l'intervalle de temps pendant lequel la tension du tube à rayons X dépasse le pourcentage sélectionné de la valeur maximale.